# EUROPÄISCHE PATENTANMELDUNG

(11) **EP 0 689 056 A2**
(43) Veröffentlichungstag der Anmeldung: **27.12.1995**
(21) Anmeldenummer: 95250141.9
(22) Anmeldetag: 12.06.1995
(51) Int. Cl.: G01R 15/14

(54) **Messeinrichtung zur Erfassung von innerhalb einer gekapselten Hochspannungsschaltanlage erzeugten Hochfrequenzsignalen**

(30) Priorität: 23.06.1994 DE 9410813 U
(71) Anmelder: SIEMENS AKTIENGESELLSCHAFT, D-80333 München (DE)
(72) Erfinder: Achatz, Norbert, D-12163 Berlin (DE)

(57) **Zusammenfassung**

Bei einer Meßeinrichtung zur Erfassung von innerhalb einer gekapselten Hochspannungsschaltanlage, insbesondere durch Teilentladungen erzeugten Hochfrequenzsignalen ist ein Gleichrichtungselement (3) und ein diesem nachgeschalteter Wellenleiter (4), insbesondere in Form eines Hochfrequenzkabels vorgesehen, wodurch die Energie des Hochfrequenzsignals in Form einer elektromagnetischen Welle innerhalb des Wellenleiters (4) gespeichert und mittels einer Integriereinrichtung akkumuliert werden kann.

## Beschreibung

Die Erfindung bezieht sich auf eine Meßeinrichtung zur Erfassung von durch Störungen, insbesondere Teilentladungen innerhalb einer gekapselten Hochspannungsschaltanlage erzeugten Hochfrequenzsignalen mit einem Gleichrichtungselement, einem diesem nachgeschalteten Speicherelement für die von dem Gleichrichtungselement durchgelassene elektrische Energie und einem mit dem Speicherelement verbundenen Integrierelement.

Zur Ermittlung von Störungen innerhalb einer gekapselten Hochspannungsschaltanlage, beispielsweise durch Fremdpartikel oder durch Beschädigung der Isolation ist es bekannt, die bei Teilentlandungen entstehenden elektromagnetischen Hochfrequenzsignale zu erfassen und zu analysieren, um Informationen über die Art der Störung zu erhalten.

Beispielsweise ist es aus der DE-OS 37 26 287 bekannt, an einer gekapselten Schaltanlage elektrische Signale im Hochfrequenzbereich zu messen und diese in Zusammenhang mit den gleichzeitig entstehenden akustischen Signalen zu verarbeiten.

Aus der DE-OS 37 26 287 ist die Messung des Pegels eines Hochfrequenzsignals sowie die Steuerung eines Meßprozesses in Abhängigkeit von der Höhe des Pegels bekannt. Es ist jedoch dort nicht näher ausgeführt, auf welche Weise der Pegel des Hochfrequenzsignals ermittelt wird.

Aus dem Fachartikel "Operation and Diagnosis Assisting System for Substations" Hitachi Review Vol. 40 (1991), Nr. 5, Seite 359ff ist die Erfassung eines elektrischen Hochfrequenzsignals mittels eines kapazitiven Sensors und eine nachfolgende Spektralanalyse des Hochfrequenzsignals bekannt.

Der vorliegenden Erfindung liegt die Aufgabe zugrunde, eine Meßeinrichtung der eingangs genannten Art so zu gestalten, daß ein eingehendes elektrisches Hochfrequenzsignal effektiv erfaßt und in bezug auf seine Intensität ausgewertet werden kann.

Die Aufgabe wird erfindungsgemäß dadurch gelöst, daß das Speicherelement durch einen Wellenleiter, insbesondere ein Hochfrequenzkabel gebildet ist.

Das am Eingang des Gleichrichtungselementes einlaufende Hochfrequenzsignal liegt dort als eine Wechselspannung an und wird gleichgerichtet. Das bedeutet, daß am Ausgang des Gleichrichtungselementes ebenfalls elektrische Spannungsimpulse, jedoch mit ausschließlich positiver oder negativer Polarisation vorliegen, die sich in dem nachgeschalteten Wellenleiter in Form von elektromagnetischen Wellen weiterbewegen.

Der Wellenleiter muß zu diesem Zweck zur Leitung von elektromagnetischen Wellen in dem auftretenden Hochfreouenzbereich geeignet sein.

Der Wellenleiter setzt dem durch das Gleichrichtungselement durchgelassenen Hochfrequenzsignal den zeitlich konstanten, lediglich von der Beschaffenheit des Wellenleiters abhängigen Wellenwiderstand entgegen. Bei dem zu erwartenden zeitlichen Abklingen des Hochfrequenzsignals innerhalb der Zeit, in der das Signal erfaßt werden soll, ist dadurch gewährleistet, daß das vollständige Signal das Gleichrichtungselement durchläuft und in Form einer elektromagnetischen Welle in den Wellenleiter gelangt, wo es für eine begrenzte Zeit gespeichert wird. Solange innerhalb des Wellenleiters keine Signalanteile zum Eingang zurückreflektiert werden, tritt am Eingang des Wellenleiters keine Reduzierung der einfließenden HF-Signalenergie durch rücklaufende Signale auf.

Mittels einer an sich bekannten Integrierschaltung, die an den Wellenleiter angeschlossen ist, kann diesem die gesamte Energie der gespeicherten Welle in Form eines elektrischen Stroms entnommen und weiterverarbeitet werden. Der Vorteil der erfindungsgemäßen Meßeinrichtung liegt insbesondere darin, daß nur sehr wenig von der Intensität des Eingangssignals verlorengeht.

Bei der aus der Meßtechnik bekannten Schaltung mit einem dem Gleichrichtungselement nachgeschalteten Kondensator ist eine solche vollständige Erfassung des Hochfrequenzsignals nicht gegeben, wie weiter unten mit Bezug auf die Figuren näher beschrieben.

Eine vorteilhafte Ausgestaltung der Erfindung sieht vor, daß die Länge des Wellenleiters so bemessen ist, daß der Teil des von dem Gleichrichtungselement durchgelassenen Signals, der nach dem Durchlaufen des Wellenleiters und Reflexion an dessen dem Gleichrichterelement abgewandten Ende zum Eingang des Wellenleiters zurückwandert, innerhalb der Meßzeit, während der das Hochfrequenzsignal erfaßt werden soll, den Eingang des Wellenleiters nicht erreicht.

Sobald ein innerhalb des Wellenleiters reflektierter Teil der elektromagnetischen Welle zum Eingang des Wellenleiters zurückgelangt, wirkt dieser Teil auf das elektrische Eingangssignal am Eingang des Wellenleiters zurück, d. h. es wird eine Gegenspannung aufgebaut, die zu einer Reduzierung der einfließenden HF-Signalenergie in den Wellenleiter führt und die verhindert, daß die in bezug auf die Intensität unterhalb der Gegenspüannung liegenden Schwingungen des abklingenden Eingangssignals das Gleichrichtungselement passieren können.

Daher wird durch die vorteilhafte Ausgestaltung der Erfindung, d. h. eine genügende Länge des Wellenleiters sichergestellt, das innerhalb der Meßzeit keine reflektierte Welle innerhalb des Wellenleiters zu dessen Eingang zurückgelangen kann. Der Wellenleiter kann zwar langer, sollte aber nicht kürzer als in dieser Länge gebaut werden.

Eine weitere vorteilhafte Ausgestaltung der Erfindung sieht vor, daß dem Gleichrichtungselement ein Verstärkungselement vorgeschaltet ist.

Die Erfindung kann außerdem vorteilhaft dadurch ausgestaltet werden, daß das Gleichrichtungselement als Brückenschaltung von Halbleiterdioden ausgebildet ist.

Durch eine solche Schaltung werden beide Polaritäten des hochfrequenten Eingangssignals in an sich bekannter Weise ausgenutzt.

Im folgenden wird die Erfindung anhand eines Ausführungsbeispiels in einer Zeichnung gezeigt und anschließend beschrieben.

Dabei zeigt
Figur 1 schematisch eine erfindungsgemäße Meßeinrichtung,
Figur 2 eine Meßeinrichtung gemäß dem Stand der Technik.

Die Zuleitung 1 einer erfindungsgemäßen Meßeinrichtung ist mit einer Meßelektrode mit Überspannungsschutzvorrichtung innerhalb einer nicht dargestellten Hochspannungsschaltanlage verbunden. Mit der Zuleitung 1 ist ein Eingangsverstärker 2 zur Verstärkung eines hochfrequenten Signals verbunden. An den Ausgang des Eingangsverstärkers 2 ist ein Gleichrichtungselement 3 mit einer hochfrequenztauglichen Halbleiterdiode zur Gleichrichtung des Hochfrequenzsignals unter Anpassung des Eingangswiderstandes angeschlossen. Dem Gleichrichtungselement 3 ist gemäß der Erfindung ein Wellenleiter 4 in Form eines Hochfrequenzkabels nachgeschaltet. Das Hochfrequenzkabel 4 weist eine Abschirmung 5 auf, die mit dem Erdpotential verbunden ist. Es handelt sich bei dem Hochfrequenzkabel um ein Koaxialkabel, dessen zentrischer Leiter galvanisch mit dem Ausgang des Gleichrichtungselementes 3 verbunden ist und das an seinem dem Gleichrichtungselement 3 abgewandten Ende 6 mit dem Eingang einer Integrierstufe 7 verbunden ist. Die Integrierstufe 7 weist beispielsweise einen Eingangswiderstand 8, einen Operationsverstärker 9 und einen Beschaltungskondensator 10 auf. An dem Ausgang 11 der Integrierstufe 7 liegt eine Spannung an, die der über die Zeit integrierten Intensität des an der Zuleitung 1 anliegenden Hochfrequenzsignals proportional ist.

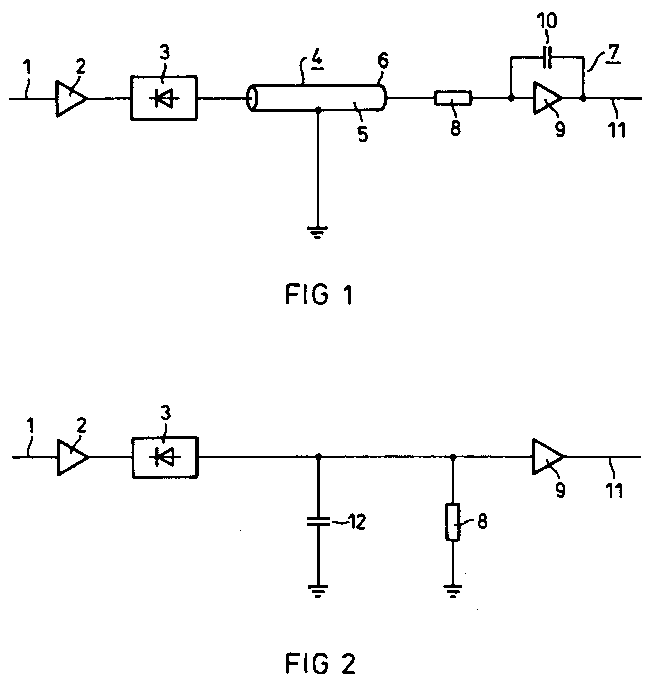

In der Figur 2 ist eine Anordnung gemäß dem Stand der Technik dargestellt, bei der die Zuleitung 1, der Eingangsverstärker 2, das Gleichrichtungselement 3, der Entladewiderstand 8, der Operationsverstärker 9 sowie der Ausgang 11 ähnlich wie bei der gemäß Figur 1 dargestellten Meßeinrichtung gestaltet sein können. Anstelle des Wellenleiters 4 ist dort jedoch ein Kondensator 12 vorgesehen, der an dem Ausgang des Gleichrichtungselementes 3 angeschlossen ist und die das Gleichrichtungselement 3 durchfließende Ladung speichert. Wenn durch das Gleichrichtungselement 3 eine bestimmte Ladungsmenge geflossen ist, ist der Kondensator 12 bis auf eine bestimmte Spannung aufgeladen, so daß der Schwellwert für eine am Eingang des Gleichrichtungselementes 3 anliegende Spannung oberhalb deren die anliegende Spannung durchgelassen wird, ansteigt, und nur oberhalb des Schwellwertes der Spannung liegende Signalanteile von dem Gleichrichtungselement 3 durchgelassen werden. Es wird also nicht die volle Intensität des Eingangssignals über die ganze Beobachtungszeit durchgelassen, so daß das mittels der Integrierstufe aufaddierte Signal nicht dem Zeitintegral über die Intensität des Hochfrequenzsignals während der gesamten Beobachtungszeit proportional ist.

Hierin liegt der Nachteil des Standes der Technik, der durch die erfindungsgemäße Meßeinrichtung vermieden wird.

Außerdem wäre gemäß dem Stand der Technik das Gleichrichtungselement im Anfangsbereich eines einlaufenden Signals kurzgeschlossen, so daß ein vorgeschalteter Verstärker stark ausgelegt werden müßte, um nicht das Signal zu verzerren.

Gemäß der Erfindung sind der Verstärker 2 und das Gleichrichtungselement 3 mit einer begrenzten, zeitlich konstanten Impedanz belastet.

## Patentansprüche

1. Meßeinrichtung zur Erfassung von durch Störungen, insbesondere Teilentladungen innerhalb einer gekapselten Hochspannungsschaltanlage erzeugten Hochfrequenzsignalen mit einem Gleichrichtungselement(3), einem diesem nachgeschalteten Speicherelement für die von dem Gleichrichtungselement (3) durchgelassene elektrische Energie und einem mit dem Speicherelement verbundenen Integrierelement,
**dadurch gekennzeichnet,**
daß das Speicherelement durch einen Wellenleiter (4), insbesondere ein Hochfrequenzkabel gebildet ist.

2. Meßeinrichtung nach Anspruch 1,
**dadurch gekennzeichnet,**
daß die Länge des Wellenleiters (4) so bemessen ist, daß der Teil des von dem Gleichrichtungselement (3) durchgelassenen Signals, der nach dem Durchlaufen des Wellenleiters (4) und Reflexion an dessen dem Gleichrichtungselement (3) abgewandten Ende zum Eingang des Wellenleiters (4) zurückwandert, innerhalb der Meßzeit, während der das Hochfrequenzsignal erfaßt werden soll, den Eingang des Wellenleiters (4) nicht erreicht.

3. Meßeinrichtung nach Anspruch 1 oder 2,
**dadurch gekennzeichnet,**
daß dem Gleichrichtungselement (3) ein Verstärkungselement vorgeschaltet ist.
